# EUROPEAN PATENT SPECIFICATION

(11) **EP 2 913 604 B1**
(45) Date of publication and mention of the grant of the patent: **21.04.2021**
(21) Application number: 13848280.7
(22) Date of filing: 11.10.2013
(51) Int. Cl.: F24S 70/12, F24S 70/16, F24S 70/225, H01L 31/0256

(54) **USE OF HEAT-TO-LIGHT CONVERSION MEMBER**
VERWENDUNG VON WÄRMEUMWANDLUNGSELEMENT
UTILISATION DE ÉLÉMENT DE CONVERSION DE LUMIÈRE À CHALEUR

(30) Priority: 26.10.2012 JP 2012237295
(43) Date of publication of application: 02.09.2015
(73) Proprietor: KABUSHIKI KAISHA TOYOTA JIDOSHOKKI, Kariya-shi, Aichi 448-8671 (JP); Japan Fine Ceramics Center, Nagoya-shi, Aichi 456-8587 (JP)
(72) Inventor: TAKEUCHI, Norihito, Kariya-shi Aichi 448-8671 (JP); NORITAKE, Kazuto, Kariya-shi Aichi 448-8671 (JP); SASATANI, Toru, Kariya-shi Aichi 448-8671 (JP); TSUTSUI, Takuhito, Kariya-shi Aichi 448-8671 (JP); OKUHARA, Yoshiki, Nagoya-shi Aichi 456-8587 (JP); SUDA, Seiichi, Nagoya-shi Aichi 456-8587 (JP)
(74) Representative: Winter, Brandl - Partnerschaft mbB
(86) International application number: PCT/JP2013/077828
(87) International publication number: WO 2014/065141

(56) References cited:
- EP-A1- 0 017 415
- EP-A1- 0 107 412
- WO-A1-82/00510
- WO-A1-2011/135974
- WO-A2-2012/128579
- AU-B2- 555 903
- FR-A1- 2 506 436
- GB-A- 2 045 283
- JP-A- S5 860 166
- JP-A- H10 153 704
- JP-A- 2006 214 654
- JP-A- 2006 229 168
- JP-A- 2010 002 077
- JP-A- 2012 506 021
- JP-A- 2013 104 617
- US-A- 4 312 915
- US-A- 4 334 523
- US-A1- 2010 212 328
- US-A1- 2012 097 206
- US-B1- 6 943 388
- FAROOQ M ET AL: "High performance sputtered Ni:SiO"2 composite solar absorber surfaces", SOLAR ENERGY MATERIALS AND SOLAR CELLS, ELSEVIER SCIENCE PUBLISHERS, AMSTERDAM, NL, vol. 54, no. 1-4, 1 July 1998 (1998-07-01) , pages 67-73, XP004148875, ISSN: 0927-0248, DOI: 10.1016/S0927-0248(97)00265-1
- LAMPERT C M: "COATINGS FOR ENHANCED PHOTOTHERMAL ENERGY COLLECTION", SOLAR ENERGY MATERIALS, NORTH-HOLLAND PUBLISHING COMPANY, AMSTERDAM, NL, vol. 1, 1 January 1979 (1979-01-01), pages 319-341, XP000900880, ISSN: 0165-1633, DOI: 10.1016/0165-1633(79)90001-7
- AGARWAL R C ET AL: "Selective blacks for enhanced photothermal solar energy conversion", ENERGY CONVERSION AND MANAGEMENT, ELSEVIER SCIENCE PUBLISHERS, OXFORD, GB, vol. 21, no. 4, 1 January 1981 (1981-01-01), pages 239-251, XP025413111, ISSN: 0196-8904, DOI: 10.1016/0196-8904(81)90020-0 [retrieved on 1981-01-01]

## Description

### Technical Field

The present invention relates to the use of a light-to-heat conversion member.

### Background Art

Photovoltaic power generation systems are known that convert sunlight to heat and utilize the heat for electric power generation. In the known systems, sunlight is collected with a collector and the collected sunlight is used to heat a heating medium (such as oil, dissolved salts or molten sodium) in a container or flow channel. Provision of covering materials, thin-films and the like on the surfaces of containers or flow channels is also being studied as a way of accelerating heating of the heating medium by the collected sunlight.

In NPL 1, for example, a covering material is provided on the surface of a container or flow channel, and the covering material promotes absorption of collected sunlight while minimizing heat release by heat radiation from the container or flow channel to the exterior. As another example, PTL 1 proposes a method for producing a solar heat collector comprising a first glass tube having a vacuum interior and allowing sunlight to impinge from the exterior, and a second glass tube or metal tube provided on the inner side of the first glass tube and having a selective absorbing film on the surface, the selective absorbing film being composed of a metal film that contacts with the second glass tube or metal tube and a dielectric thin-film adhering onto the metal film, wherein the metal film is formed by an electroless plating method selected from among nickel, cobalt, silver and copper plating, and the dielectric thin-film is formed by coating a film by a method of coating a solution of one kind or a mixture selected from among titanium dioxide, tantalum pentoxide and niobium pentoxide, followed by heat treatment of the film at 500°C or higher in an oxidizing atmosphere. Also, PTL 2 proposes a coating composition for the heat-collecting surface of a solar heat collector, comprising a pigment with a high solar absorption rate that is highly permeable to infrared rays, polymethylpentene, and a solvent that dissolves polymethylpentene, while PTL 3 proposes a solar heat collecting apparatus utilizing sunlight energy, the solar heat collecting apparatus comprising a wavelength converter that absorbs at least a portion of sunlight and converts it to light of a different wavelength, and a heat accumulator that absorbs light emitted from the wavelength converter and generates heat. In addition, PTL 4 proposes a sunlight selective absorption coating having a sunlight absorbing property and low emissivity, the sunlight selective absorption coating comprising a support (1) of a metal, dielectric material or ceramic material, at least one mid-to-far-infrared ray highly-reflecting metal layer (2) accumulated on the support (1), a multilayer absorbing structure (3) composed of an alternating dielectric layer (5) and metal layer (6), accumulated on the metal reflective layer (2), and at least one anti-reflection dielectric layer (4), accumulated on the multilayer absorbing structure (3), the dielectric layers (5) of the multilayer absorbing structure (3) being either of the same or different thicknesses and/or compositions, the metal layers (6) of the multilayer absorbing structure (3) being either of the same or different thicknesses and/or compositions, the respective thicknesses of the metal layers (6) and dielectric layers (5) of the multilayer absorbing structure (3) being less than 10 nm and preferably less than 1 nm, the total thickness of the multilayer absorbing structure (3) being 5-1000 nm, wherein it is specified that the layer of the dielectric material of the sunlight selective absorption coating is accumulated by reactive sputtering including an inert gas and a reactive gas in a chamber or a part of a chamber in which the dielectric layer is to be accumulated, and the metal layer of the sunlight selective absorption coating is accumulated by DC sputtering, introducing only an inert gas into a chamber or part of a chamber in which the metal sheet is to be accumulated.
PTL 5 and PTL 6 disclose doped semiconductors. A semiconductor layer of PTL 5 is doped with antimony. PTL 6 discloses a rutile type titanium oxide doped with transition metal ions.
PTL 7 discloses a use of a light-to-heat conversion member in accordance with the preamble of claim 1.

### Citation List

### Patent Literature

[PTL 1] Japanese Unexamined Patent Publication No. 59-056661
[PTL 2] Japanese Unexamined Patent Publication No. 58-001760
[PTL 3] Japanese Unexamined Patent Publication No. 2010-002077
[PTL 4] Japanese Patent Public Inspection No. 2012-506021
[PTL 5] FR 2506436 A1
[PTL 6] WO 2011/135974 A1
[PTL 7] AU 555 903 B2

### [Non Patent Literature]

[NPL 1] July 2002, NREL/TP-520-31267, "Review of Mid-to High-Temperature Solar Selective Absorber Materials", C.E. Kennedy.

### SUMMARY OF INVENTION

### Technical Problem

At the current time, it is desirable to achieve more accelerated heating of heating media by collected sunlight and achieve more efficient light-to-heat conversion.

It is an object of the present invention to provide the use of a light-to-heat conversion member to efficiently convert light to heat.

### Solution to Problem

The means for achieving these objects is described by the following (1) to (6).
(1) Use of a light-to-heat conversion member for converting light to heat, the member comprising a composite material of one or more kinds of semiconductor and one or more kinds of metal material, wherein the metal material is dispersed within the semiconductor, and the metal material is in the form of particles, and wherein the metal material comprises one or more of Ag material, Mo material, and Cu material, and the semiconductor comprises FeSi_{X} (X = 0.5-4).
(2) The use according to (1), wherein X in FeSix is 2.
(3) The use according to (1) or (2), wherein the member is film-shaped.
(4) The use according to (3), wherein the film shape has a thickness of 1 nm to 10 µm.
(5) Use of a light-to-heat conversion laminate for converting light to heat, the laminate having laminated at least one or more layers including the light-to-heat conversion member as specified in (3) or (4), and a metal layer.
(6) Use of a light-to-heat conversion laminate for converting light to heat, the laminate having laminated at least a metal layer, one or more layers including the light-to-heat conversion member as specified in (3) or (4), and a transparent dielectric layer, in that order.

### Advantageous Effects of Invention

According to the present invention, there is provided the use of a light-to-heat conversion member that can efficiently convert light to heat.

### Brief Description of Drawings

Fig. 1 is a cross-sectional schematic drawing showing the use of a light-to-heat conversion member in a heat conversion laminate 1 as one embodiment according to the present invention.
Fig. 2 is a graph showing the results for the absorption properties of a Ag-FeSi₂ "metasemi" monolayer film.
Fig. 3 is a graph showing the results for the absorption properties of a Mo-FeSi₂ "metasemi" monolayer film.
Fig. 4 is a graph showing the results for the absorption properties of a Cu-FeSi₂ "metasemi" monolayer film.

### Description of the heat conversion member and laminate

### (1) Heat conversion member

The heat conversion member comprises a composite material of one or more kinds of semiconductor and one or more kinds of metal material. The heat conversion member allows the absorption property for sunlight to be varied by adjusting the content (addition rate) of the one or more kinds of metal material, thereby allowing efficient conversion of light to heat with improved optical selectivity. Here, "optical selectivity" refers to dramatic change in the optical characteristics, such as reflectance at certain wavelengths or certain wavelength ranges.

The one or more kinds of semiconductor in the composite material in the heat conversion member (also referred to as "composite material") may be of a single kind of semiconductor, or a mixture of two or more different kinds of semiconductor.

The semiconductor of a composite material in the heat conversion member comprises FeSi_{X} (X = 0.5-4).

The one or more kinds of metal material in the composite material in the heat conversion member may also be a single kind of metal material or a mixture of two or more different kinds of metal material.

The metal material in the composite material in the heat conversion member comprises one or more of an Ag material, Mo material or Cu material.

The one or more kinds of metal material in the composite material in the heat conversion member is in the form of particles. Said material may be metallic particles or metal fine particles. The particle diameter of particles of the metal material is preferably 1-100 nm.

The one or more kinds of semiconductor in the composite material in the heat conversion member comprises FeSi_{X} (X = 0.5-4) and more preferably comprises FeSi₂.

The heat conversion member may be in any desired form, such as in the form of a film shape, tube shape, sheet shape or the like, however a film shape is preferred. The thickness of a film of the heat conversion member may be any desired thickness so long as the effect of the present invention is exhibited, however preferably a film of the heat conversion member has a thickness of 1 nm to 10 µm, and more preferably it has a thickness of 5 nm to 100 nm.

The content of the one or more kinds of metal material in the heat conversion member may be as desired, such as 1-50 vol%, for example.

The heat conversion member may yet also contain any desired material other than a composite material of the one or more kinds of semiconductor and one or more kinds of metal materials. For example, a transparent dielectric material such as SiO₂ may be mixed in the form of particulates or fine particulates.

The heat conversion member can be obtained by any desired publicly known production method. For example, the heat conversion member can be produced by physical vapor phase deposition (PVD), sputtering or the like.

### (2) Heat conversion laminate

As one feature, the heat conversion laminate has laminated one or more layers comprising a film-like heat conversion member and a metal layer, and it may have a metal layer and one or more layers comprising a film-like heat conversion member laminated in that order, or the lamination may be in the reverse order.

As another feature, the heat conversion laminate may also have at least a metal layer, one or more layers comprising a film-like heat conversion member and a transparent dielectric layer, laminated in that order.

The one or more layers containing a film-like heat conversion member in the heat conversion laminate may be constructed as a photoabsorbing layer, and this allows the absorption property for sunlight to be varied by adjusting the content of the one or more kinds of metal material, thereby allowing efficient conversion of light to heat with improved optical selectivity. The thickness of the one or more layers comprising a film-like heat conversion member in the heat conversion laminate may be any desired thickness so long as the effect of the present invention is exhibited, and it is preferably a thickness of 5 nm to 100 nm. The layer comprising the film-like heat conversion member in the heat conversion laminate may be a single layer or multiple layers. The one or more layers comprising a film-like heat conversion member in the heat conversion laminate may also include any materials other than the film-like heat conversion member.

The metal layer in the heat conversion laminate may be constructed as an infrared anti-reflection layer. The metal layer in the heat conversion laminate is not particularly restricted, and for example, it may be a molybdenum (Mo) layer, tungsten (W) layer, silver (Ag) layer, gold (Au) layer, copper (Cu) layer or the like, and is preferably a molybdenum (Mo) layer. The thickness of the metal layer in the heat conversion laminate may have any desired thickness so long as the effect of the present invention is exhibited, and it is preferably a thickness of 100 nm or greater.

The transparent dielectric layer in the heat conversion laminate may also be constructed as an anti-reflection layer. The transparent dielectric layer in the heat conversion laminate is not particularly restricted, and examples include a SiO₂ layer, Al₂O₃ layer, AlN layer or the like, with a SiO₂ layer being preferred. The thickness of the transparent dielectric layer in the heat conversion laminate may be any desired thickness so long as the effect of the present invention is exhibited, and it is preferably a thickness of 10 nm to 500 nm.

The heat conversion laminate may also include an absorbing layer other than a heat conversion member of the present invention, as a photoabsorbing layer.

The heat conversion laminate can be obtained by any desired publicly known production method. For example, the heat conversion laminate can be produced by physical vapor phase deposition (PVD), sputtering or the like.

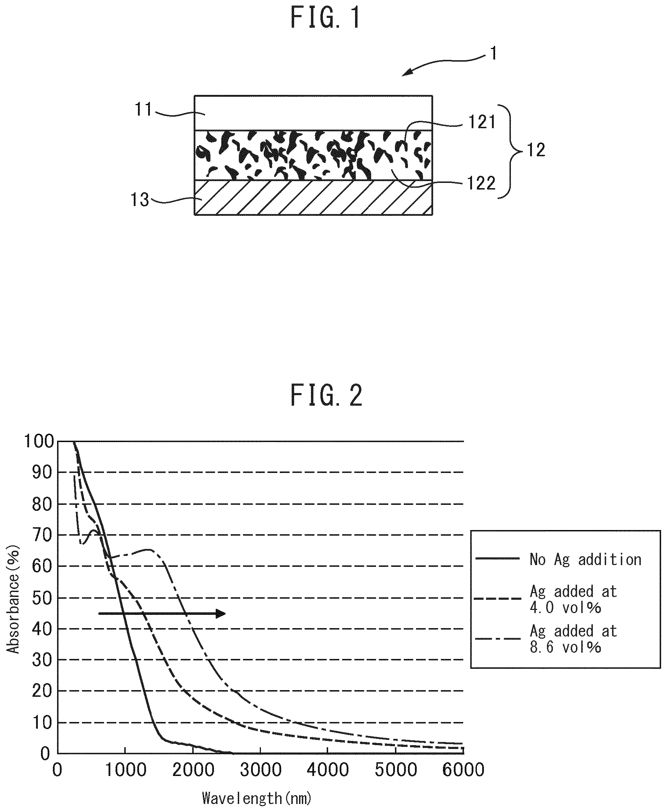

The heat conversion laminate will now be explained in greater detail with reference to Fig. 1.

Fig. 1 is a drawing showing a heat conversion laminate 1. The heat conversion laminate 1 is formed from a transparent dielectric layer 11, a layer comprising a heat conversion member (photoabsorbing layer) 12, and a metal layer 13. Also, the layer comprising a heat conversion member (photoabsorbing layer) 12 comprises metal fine particles 121 and a semiconductor 122. As shown in Fig. 1, the metal fine particles 121 are dispersed within the semiconductor 122.

### Examples

Examples will now be provided for a more concrete explanation of the present invention. The present invention is not limited to these examples, however, provided that the object and gist of the present invention are maintained.

### <Evaluation of absorption properties of heat conversion member>

The absorption properties of heat conversion members were evaluated using Examples 1 to 3 and Comparative Example 1.

### (Example 1)

The absorption properties of a heat conversion member were evaluated using an Ag-FeSi₂ "metasemi" monolayer film. The term "metasemi" means "metal + semiconductor".

### [Method of forming Ag-FeSi₂ metasemi monolayer film]

On a quartz substrate at room temperature, FeSi₂ and Ag (silver) were simultaneously sputtered to form a film. Following film formation, annealing was performed for 1 hour in a vacuum furnace at a temperature of no higher than 800°C. Two Ag-FeSi₂ metasemi samples with different Ag (silver) addition rates (4.0 vol%, 8.6 vol%) were prepared.

The optical constants (refractive index n, extinction coefficient k) of the Ag-FeSi₂ metasemi were calculated for the obtained sample from the measurement data with a spectroscopic ellipsometer and the reflectance property and transmittance property measured with a spectrophotometer.

The calculated multilayer film approximation based on the optical constants (n, k) for Ag-FeSi₂ metasemi was used to calculate the absorption rate of the Ag-FeSi₂ metasemi monolayer film (corresponding to a film thickness of 30 nm). Fig. 2 shows the results for the absorption properties of a Ag-FeSi₂ metasemi monolayer film.

### (Example 2)

The absorption properties of a heat conversion member were evaluated using a Mo-FeSi₂ metasemi monolayer film.

### [Method of forming Mo-FeSi₂ metasemi monolayer film]

On a quartz substrate heated to a temperature no higher than 700°C, FeSi₂ and Mo (molybdenum) were simultaneously sputtered to form a film. Two Mo-FeSi₂ metasemi samples with different Mo (molybdenum) addition rates (4.2 vol%, 9.4 vol%) were prepared.

The optical constants (refractive index n, extinction coefficient k) of the Mo-FeSi₂ metasemi were calculated for the obtained sample from the measurement data with a spectroscopic ellipsometer and the reflectance property and transmittance property measured with a spectrophotometer.

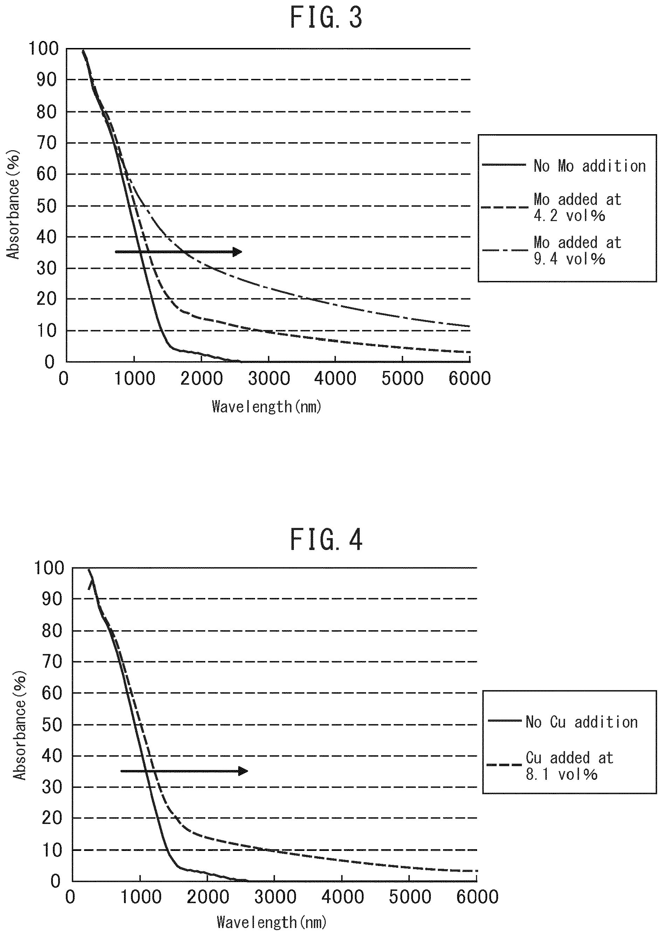

The calculated multilayer film approximation based on the optical constants (n, k) for Mo-FeSi₂ metasemi was used to calculate the absorption rate of the Mo-FeSi₂ metasemi monolayer film (corresponding to a film thickness of 30 nm). Fig. 3 shows the results for the absorption properties of a Mo-FeSi₂ metasemi monolayer film.

### (Example 3)

The absorption properties of a heat conversion member were evaluated using an Cu-FeSi₂ metasemi monolayer film.

### [Method of forming Cu-FeSi₂ metasemi monolayer film]

On a quartz substrate heated to a temperature no higher than 700°C, FeSi₂ and Cu (copper) were simultaneously sputtered to form a film. A Cu-FeSi₂ metasemi sample with a Cu (copper) addition rate of 8.1 vol% was prepared.

The optical constants (refractive index n, extinction coefficient k) of the Cu-FeSi₂ metasemi were calculated for the obtained sample from the measurement data with a spectroscopic ellipsometer and the reflectance property and transmittance property measured with a spectrophotometer.

The calculated multilayer film approximation based on the optical constants (n, k) for Cu-FeSi₂ metasemi was used to calculate the absorption rate of the Cu-FeSi₂ metasemi monolayer film (corresponding to a film thickness of 30 nm). Fig. 4 shows the results for the absorption properties of a Cu-FeSi₂ metasemi monolayer film.

### (Comparative Example 1)

The absorption properties of a FeSi₂ monolayer film were evaluated.

### [Method of forming FeSi₂ monolayer film]

On a quartz substrate heated to a temperature no higher than 700°C, FeSi₂ was sputtered to form a film. A FeSi₂ sample was fabricated.

The optical constants (refractive index n, extinction coefficient k) of the FeSi₂ were calculated for the obtained sample from the measurement data with a spectroscopic ellipsometer and the reflectance property and transmittance property measured with a spectrophotometer.

The calculated multilayer film approximation based on the optical constants (n, k) for FeSi₂ was used to calculate the absorption rate of the FeSi₂ monolayer film (corresponding to a film thickness of 30 nm). Fig. 2 to Fig. 4 show the results for the absorption properties of a FeSi₂ monolayer film.

### <Evaluation results>

Referring to Fig. 2, it is seen that the absorption property curve shifts toward the long wavelength end as the amount of Ag (silver) addition increases (0 vol% → 4.0 vol% → 8.6 vol%). Thus, since the sunlight absorption property of the Ag-FeSi₂ metasemi monolayer film can be varied by adjusting the Ag (silver) material content (amount of addition), it is possible to increase the optical selectivity and accomplish efficient conversion of light to heat.

Referring to Fig. 3, it is seen that the absorption property curve shifts toward the long wavelength end as the amount of Mo (molybdenum) addition increases (0 vol% → 4.2 vol% → 9.4 vol%). Thus, since the sunlight absorption property of the Mo-FeSi₂ metasemi monolayer film can be varied by adjusting the Mo (molybdenum) material content (amount of addition), it is possible to increase the optical selectivity and accomplish efficient conversion of light to heat.

Referring to Fig. 4, it is seen that the absorption property curve shifts toward the long wavelength end as the amount of Cu (copper) addition increases (0 vol% → 8.1 vol%). Thus, since the sunlight absorption property of the Cu-FeSi₂ metasemi monolayer film can be varied by adjusting the Cu (copper) material content (amount of addition), it is possible to increase the optical selectivity and accomplish efficient conversion of light to heat. Thus, the absorption property curve can be shifted toward the long wavelength end compared to a FeSi₂ monolayer film, as shown in Figs. 2 to 4, and optical selectivity is maintained even after shifting. It is therefore possible to use the heat conversion member in place of a FeSi₂ monolayer film. In this case, the heat conversion member may be laminated on a metal layer as an infrared ray-reflective layer, and a transparent dielectric layer may be additionally formed as an anti-reflection layer.

### (Example 4)

The properties of a laminate according to the previous embodiments were evaluated.

The properties of a laminate prepared by laminating a metal layer, a metasemi layer (photoabsorbing layer) and a transparent dielectric layer in that order were evaluated by calculating the absorption rate using multilayer film approximation, in the same manner, and a shift in properties toward the long wavelength end was confirmed, similar to a monolayer film.

### Reference Signs List

1 Heat conversion laminate
11 Transparent dielectric layer
12 Layer comprising heat conversion member
   (photoabsorbing layer)
13 Metal layer
121 Metal fine particles
122 Semiconductor

## Claims

1. Use of a light-to-heat conversion member (12) for converting light to heat, the member (12) comprising a composite material of one or more kinds of semiconductor (122) and one or more kinds of metal material (121), wherein
the metal material (121) is in the form of particles, wherein
the metal material (121) comprises one or more of Ag material, Mo material, and Cu material, **characterized in that** the metal material (121) is dispersed within the semiconductor (122), and
the semiconductor (122) comprises FeSix (X = 0.5-4).

2. The use according to claim 1, wherein X in FeSix is 2.

3. The use according to claim 1 or 2, which has a film shape.

4. The use according to claim 3, wherein the film shape has a thickness of 1 nm to 10 µm.

5. Use of a light-to-heat conversion laminate (1) for converting light to heat, the laminate (1) having laminated at least one or more layers including the light-to-heat conversion member (12) as specified in claim 3 or 4, and a metal layer (13).

6. Use of a light-to-heat conversion laminate (1) for converting light to heat, the laminate (1) having laminated at least a metal layer (13), one or more layers including the light-to-heat conversion member (12) as specified in claim 3 or 4, and a transparent dielectric layer (11), in that order.

## Patentansprüche

1. Verwendung eines Licht-Wärme-Umwandlungselements (12) zum Umwandeln von Licht in Wärme, wobei das Element (12) ein Verbundmaterial aus einer oder mehreren Arten von Halbleiter (122) und einer oder mehreren Arten von Metallmaterial (121) umfasst, wobei
das Metallmaterial (121) in der Form von Partikeln vorliegt, wobei
das Metallmaterial (121) eines oder mehrere aus Ag-Material, Mo-Material und Cu-Material umfasst,
**dadurch gekennzeichnet, dass**
das Metallmaterial (121) in dem Halbleiter (122) dispergiert ist, und
der Halbleiter (122) FeSix (X = 0,5-4) umfasst.

2. Verwendung nach Anspruch 1, wobei X in FeSix 2 ist.

3. Verwendung nach Anspruch 1 oder 2, welches eine Folienform aufweist.

4. Verwendung nach Anspruch 3, wobei die Folienform eine Dicke von 1 nm bis 10 µm aufweist.

5. Verwendung eines Licht-Wärme-Umwandlungslaminats (1) zur Umwandlung von Licht in Wärme, wobei das Laminat (1) zumindest eine oder mehrere Schichten umfassend das Licht-Wärme-Umwandlungselement (12) nach Anspruch 3 oder 4 und eine Metallschicht (13) auflaminiert hat.

6. Verwendung eines Licht-Wärme-Umwandlungslaminats (1) zur Umwandlung von Licht in Wärme, wobei das Laminat (1) in dieser Reihenfolge zumindest eine Metallschicht (13), eine oder mehrere Schichten umfassend das Licht-Wärme-Umwandlungselement (12) nach Anspruch 3 oder 4, und eine transparente dielektrische Schicht (11) auflaminiert hat.

## Revendications

1. Utilisation d'un élément de conversion lumière-à-chaleur (12) pour convertir de la lumière en chaleur, l'élément (12) comprenant un matériau composite d'un ou plusieurs types de semiconducteur (122) et d'un ou plusieurs types de matériau de métal (121),
dans laquelle le matériau de métal (121) est dans la forme de particules,
dans laquelle le matériau de métal (121) comprend un ou plusieurs d'un matériau de Ag, matériau de Mo, et matériau de Cu, **caractérisée** en en ce que le matériau de métal (121) est dispersé dans le semiconducteur (122), et
le semiconducteur (122) comprend FeSix (X = 0,5-4).

2. Utilisation selon la revendication 1, dans laquelle X dans FeSix est égal à 2.

3. Utilisation selon la revendication 1 ou 2, qui présente une forme de film.

4. Utilisation selon la revendication 3, dans laquelle la forme de film présente une épaisseur de 1 nm à 10 µm.

5. Utilisation d'un stratifié de conversion lumière-à-chaleur (1) pour convertir de la lumière en chaleur, le stratifié (1) présentant stratifiées au moins une ou plusieurs couches incluant l'élément de conversion lumière-à-chaleur (12) comme spécifié dans la revendication 3 ou 4, et une couche de métal (13).

6. Utilisation d'un stratifié de conversion lumière-à-chaleur (1) pour convertir de la lumière en chaleur, le stratifié (1) présentant stratifiées au moins une couche de métal (13), une ou plusieurs couches incluant l'élément de conversion lumière-à-chaleur (12) comme spécifié dans la revendication 3 ou 4, et une couche diélectrique transparente (11), dans cet ordre.
